Europäisches Patentamt

European Patent Office

Office européen des brevets

(11) Publication number: **0 098 922**
**A2**

(12) # EUROPEAN PATENT APPLICATION

(21) Application number: **83103161.2**

(22) Date of filing: **30.03.83**

(51) Int. Cl.³: **G 03 F 7/02**

(30) Priority: **13.07.82 US 397737**

(43) Date of publication of application:
**25.01.84 Bulletin 84/4**

(84) Designated Contracting States:
**DE FR GB**

(71) Applicant: **International Business Machines
Corporation
Old Orchard Road
Armonk, N.Y. 10504(US)**

(72) Inventor: **Bassous, Ernest
4465 Douglas Avenue
Bronx New York 10471(US)**

(74) Representative: **Hobbs, Francis John
IBM United Kingdom Patent Operations Hursley Park
Winchester Hants, SO21 2JN(GB)**

(54) Process for selectively generating positive and negative resist patterns from a single exposure pattern.

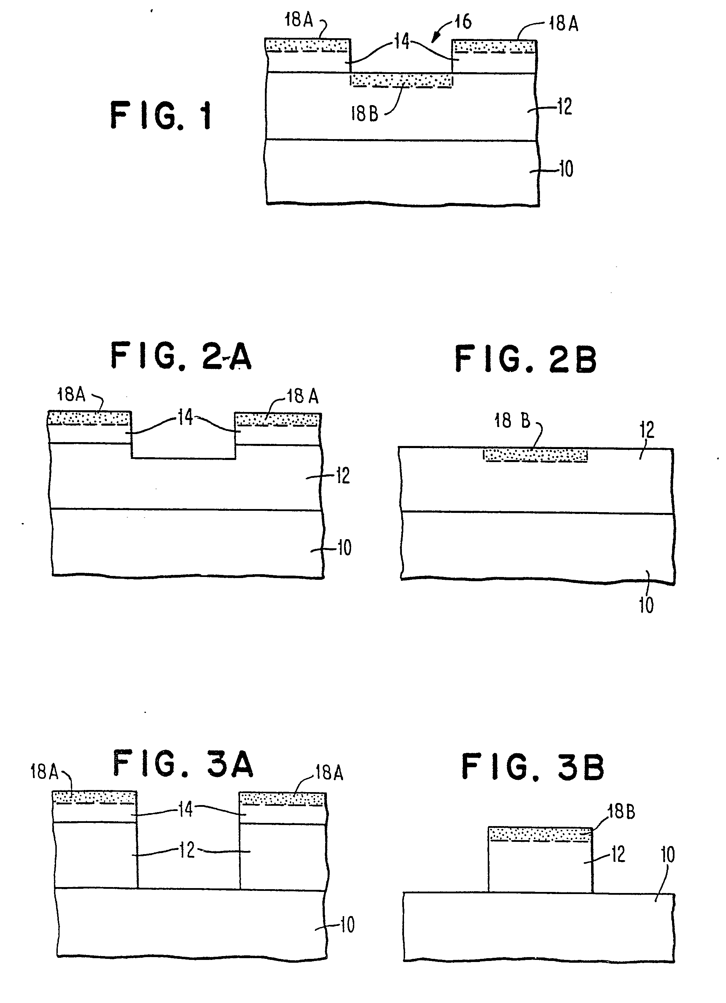

(57) A resist pattern having either positive or negative correspondence to a single exposure pattern is produced in the following manner. The surface of a two layer (12, 14) resist structure on a substrate (10) is exposed to radiation and development to remove portions (16) of the outer resist layer (14). A surface region (18A, 18B) of the remaining resist structure is doped with an ultraviolet radiation absorbing dopant material. Depending on whether a final resist pattern bearing a positive or negative correspondence to the single exposure pattern is desired, either (Figure 2A) the doped portions (18B) of the lower resist layer (12) or (Figure 2B) the whole of the upper resist layer (14) is removed. The remaining structure is then flood exposed to ultraviolet radiation and developed to remove resist material unprotected by the dopant material.

FIG. 1

EP 0 098 922 A2

## PROCESS FOR SELECTIVELY GENERATING POSITIVE AND NEGATIVE
## RESIST PATTERNS FROM A SINGLE EXPOSURE PATTERN

This invention relates to methods of forming resist patterns on a substrate by photo-lithographic techniques, and more particularly to forming resist patterns on a substrate by exposing a radiation sensitive resist structure to such radiation and then selectively removing the resist by etching or developing.

It is well established that either positive or negative resists can be employed to create etch masks for the formation of corresponding patterns on a substrate. However, a process wherein either a positive or negative resist pattern is obtained by a single exposure step is not available in the prior art.

In the present invention, the process described includes a step of doping, that is, introducing impurities into, a resist to alter the spectral absorption characteristics of the resist. In a publication by E. Bassous, L.H. Kaplan and B.J. Lin in the IBM Technical Disclosure Bulletin, Volume 23, No. 7B, December 1980 on page 3387, the use of an absorptive additive in photoresists to cause them to become opaque in the deep ultraviolet (UV) light region is described.

More particularly, the publication discusses the addition of an absorber such as acridine and its derivatives to resists to make the resist very useful for high resolution deep UV lithography.

The present invention employs a similar step of adding an absorber to a photoresist, however, it differs in that the absorber is introduced into a thin region of an exposed resist.

The invention seeks to provide a process for forming a resist pattern having either positive or negative correspondence to a single exposure pattern.

Thus, in accordance with the invention, a method for creating a resist pattern on a substrate comprises the steps of

forming a structure composed of the substrate, a first resist layer of ultraviolet radiation sensitive material on the substrate and a second resist layer of radiation sensitive resist material on the first resist layer,

exposing the second resist layer to a pattern of radiation and developing the second resist layer to produce a first pattern of material consisting of the remaining portions of the second resist layer on the surface of the first resist layer,

introducing an ultraviolet radiation absorbing dopant material into a surface region of the uncovered portions of the first resist layer and the remaining portions of the second resist layer,

either removing the doped surface region of the uncovered portions of the first resist layer or entirely removing the second resist layer,

and flood exposing the surface of the remaining structure to ultraviolet radiation and developing to create a resist pattern formed of the portions of said first resist layer covered by a surface region into which said ultraviolet radiation absorbing dopant material had been introduced.

How the invention can be carried out will now be described by way of example, with reference to the accompanying drawings, in which:-

FIG. 1 is a diagrammatic cross-section of part of a substrate supporting exposed and developed resist layers. FIGS. 2A and 3A illustrate how the structure of FIG. 1 may be processed to form a positive pattern; and

FIGS 2B and 3B illustrate how the structure of FIG. 1 may be processed to form a negative pattern.

Photo-lithographic technology is widely used in the formation of circuit configurations on semiconductor chips or substrates. A circuit configuration is produced from a pattern formed in a radiation sensitive resist layer, by exposing the resist layer to optical or electron beam radiation and then developing the resist layer to remove selected portions of it. The remaining portion of the resist layer on the substrate is then employed as an etching mask. Normally, there are two types of resist: positive and negative. When exposed to radiation and developed, the exposed positive resist is stripped away leaving a positive pattern whereas for a similar exposure on negative resist, the exposed negative resist hardens in development and remains, forming a negative pattern of the original exposure on the substrate. Thus, for a single exposure, one type of pattern, negative or positive, will result depending on the type of resist employed.

The present invention is concerned with a process using doping materials in combination with a two layer resist structure such that after a single exposure in a predetermined pattern, either a positive or a negative version of the exposure pattern may be obtained as desired.

Referring to FIG. 1, a substrate 10 is coated with a first layer 12 of resist which is sensitive to ultraviolet (UV) light, preferably in the low wavelength region below 300 nanometers. An example of such a resist is polymethyl methacrylate (PMMA).

A second resist layer 14 is coated over the layer 12. Layer 14 may be composed of positive acting photoresist which is optically sensitive to a different region of the spectrum to that of the resist layer 12, such as sensitized novolak-based resist which is sensitive above 300 nanometers. Layer 14 may also be an electron-beam sensitive resist layer. It should be noted that layer 12 is relatively thick and serves to planarize the surface of substrate 10, thereby permitting layer 14 to be relatively thin. Thus, a two layer resist structure is provided wherein one resist layer is sensitive to low wavelengths, for example, in a particular embodiment below 300 nanometers and the other layer is sensitive to higher wavelengths which may be above 300 nanometers.

The upper surface of the structure (i.e., layer 14) is then exposed to electron beam or visible radiation (depending on the resist employed), using a suitable mask or by a controlled beam to form a desired exposure pattern and then developed to remove portions 16 of layer 14 to form a patterned layer.

Next, the entire surface of the structure including both the upper, patterned resist layer 14, and the lower, thicker layer 12, are doped by the introduction, such as by diffusion, of ultraviolet absorbers.

It is known from the previously mentioned Bassous et al publication that the introduction of dopant impurities will alter the spectral characteristics of a region of a resist film in high resolution photo-lithographic processes. Such dopants are materials which absorb ultraviolet radiation in regions of the spectrum in which the resists are sensitive. Because of their high UV absorption, very small amounts of impurities introduced into a resist film produce large changes in the film's transmission spectrum without significantly affecting the resist's other properties such as solubility, adhesion, and etch-resistance. Examples of UV absorbers which are potentially useful as resist dopants are naphthalene, anthracene, 9, 10 dibromoanthracene, acridine, phthalazine and phenazine. These organic compounds are readily available commercially and possess stable properties.

If the introduction of the dopants into the resist layers of FIG. 1 is by diffusion, the diffusion of the structure may be performed in the vapor phase at a relatively low temperature inside a closed chamber containing one or more dopants. Doping from liquid solutions can also be used, but might be less attractive than doping from the vapor phase because the resist film is subjected to the influence of the solvent which might not be desirable in some applications.

Thus, an exposed, developed (patterned) structure incorporating a diffused UV absorbing layer (18A, 18B) is provided as shown in FIG. 1. This structure, having had only a single exposure to a predetermined pattern, may be used to provide either a positive or negative version of the exposure pattern as desired.

If a positive version of the pattern is desired, the doped region (18B) of the layer 12 is removed at a much faster rate than layer 14 by reactive ion etching, plasma etching or the like to provide the structure illustrated in FIG. 2A. The upper surface of structure of FIG. 2A is then "flood" exposed by deep UV radiation.

Deep UV radiation, for example, is radiation in the 200 to 300 nanometer wavelength range which is used to "flood" or totally cover the structure of FIG. 2A. The lower resist layer 12, being composed of material sensitive to wavelengths below 300 nanometers, will be sensitized by the deep UV radiation. It is the function of the doped regions of layer 14 completely to block the deep UV radiation. In the positive pattern case of FIG. 2A, the deep UV radiation is also blocked in part by the presence of the non-doped portion of layer 14 which is sensitive to wavelengths above 300 nanometers, as well as by the doped portion. In view of the presence of the non-doped resist layer 14, acridine or anthracene alone, for example, may be used as the dopant material. If, on the other hand, an extremely thin resist layer 14 is used, which is possible and desirable for high-resolution lithography, then the non-doped portion of layer 14 may be transmissive to the deep UV flood radiation and stronger dopants may be required such as used in the case of obtaining a negative pattern described hereinbelow.

After the flood exposure of the structure of FIG. 2A to the deep UV radiation, the sensitized region of layer 12 which is not located under the doped portions of layer 14 is developed and removed, leaving the regions under the doped portions of layer 14 on the substrate 10 as shown in FIG. 3A, thereby providing a positive version of the original exposure pattern.

On the other hand, if a negative pattern is desired, the layer 14 of FIG. 1 is removed by selective solvents or developers to provide the structure illustrated in FIG. 2B, where only layer 12 remains on the substrate 10. The structure of FIG. 2B is exposed to deep UV radiation just as in the case of FIG. 2A, and then developed. Only the material under the doped region of layer 12 which is opaque to the UV radiation will remain on the substrate 10 to provide the patterned structure illustrated in FIG. 3B which is the negative version of the original exposure pattern.

It should be noted that in FIG. 2B, there is no extra layer of resist material sensitive to higher UV wavelengths disposed under the doped region, as was the case for FIG. 2A. Thus, all the blockage of the deep UV radiation must be by the doped region alone. Thus, an example of dopants suitable for the case of FIG. 2B would be a mixture of napthalene and acridine, which possess strong absorption bands at 220 nanometers and 250 nanometers respectively which are regions of the spectrum to which PMMA is most sensitive.

One skilled in the art will appreciate that the positive and negative patterns shown in the illustrations of FIGS 3A and 3B are very simple for purposes of explanation, and that the described process may be used to create more complex image patterns for microcircuitry applications. Among other advantages over the prior art, in the described process the imaging resist employed does not have to be opaque to deep UV since it is subsequently doped, and, for the same reason, a much thinner imaging layer may be used. Furthermore, as previously stated, either positive or negative versions of a pattern can be delineated from the same pattern exposure step, such pattern exposure step using actinic, electron beam or X-ray radiation onto a first resist layer, followed by a doping step and flood exposure of a second resist layer.

One skilled in the art will also appreciate that the materials mentioned as suitable for resists and dopants and the wavelengths and other specific values set forth are for purposes of explanation, and that other suitable equivalents and ranges may also be employed in carrying out the described invention.

There has been described a process which is particularly well suited for providing positive or negative patterns from the same image exposure over topographically structured surfaces as typically encountered in VLSI fabrication.

CLAIMS

1.    A method for creating a resist pattern on a substrate (10) comprising the steps of:

forming a structure composed of the substrate (10), a first resist layer (12) of ultraviolet radiation sensitive material on the substrate and a second resist layer (14) of radiation sensitive resist material on the first resist layer (12),

exposing the second resist layer (14) to a pattern of radiation and developing the second resist layer (14) to produce a first pattern of material consisting of the remaining portions of the second resist layer on the surface of the first resist layer,

introducing an ultraviolet radiation absorbing dopant material into a surface region of the uncovered portions (18B) of the first resist layer and the remaining portions (18A) of the second resist layer,

either (A) removing the doped surface region (18A) of the uncovered portions of the first resist layer or (B) entirely removing the second resist layer (14),

and flood exposing the surface of the remaining structure to ultraviolet radiation and developing to create a resist pattern formed of the portions of said first resist layer covered by a surface region (18A or 18B) into which said ultraviolet radiation absorbing dopant material nad been introduced.

2.   A method for creating a resist pattern on a substrate, comprising
     the steps of:

     forming a structure composed of the substrate, a first resist layer
     of ultraviolet radiation sensitive material on the substrate and a
     second resist layer of radiation sensitive resist material on the
     first resist layer,

     selectively exposing the second resist layer to a pattern of
     radiation and developing the second resist layer to produce a
     pattern of material consisting of the remaining portions of the
     second resist layer on the surface of the first resist layer,

     introducing an ultraviolet radiation absorbing dopant material into
     a surface region of the uncovered portions of the first resist
     layer and the remaining portions of the second resist layers,

     etching away the doped surface region of the uncovered portions of
     the first resist layer,

     and flood exposing the surface of the remaining structure to
     ultraviolet radiation and developing the exposed surface to remove
     the uncovered portions of the first resist layer and thereby to
     create a pattern formed of portions of the first resist layer and
     bearing a positive correspondence to the pattern of selective
     exposure.

3.   A method for creating a resist pattern on a substrate comprising
     the steps of:

     forming a structure composed of the substrate, a first resist layer
     of ultraviolet radiation sensitive material on the substrate and a
     second resist layer of radiation sensitive material on the first
     resist layer,
     selectively exposing the second resist layer to a pattern of
     radiation and developing the second resist layer to produce a pattern in the form of the remaining portions of the second resist layer on the surface of the first resist layer,

introducing an ultraviolet radiation absorbing dopant material into a surface region of the uncovered portions of the first resist layer and the remaining portions of the second resist layer,

etching away the whole of the second resist layer to exposed both the doped and undoped surface portions of the first resist layer,

and flood exposing the uncovered surface of the first resist layer to ultraviolet radiation and developing the exposed surface to remove the portions of the first resist layer unprotected by a doped surface region and thereby to create a pattern formed of portions of the first resist layer covered by the doped surface region and bearing a negative correspondence to the pattern of selective exposure.

4.   A method as claimed in any preceding claim, in which said ultraviolet radiation absorbing dopant material is selected from naphthalene, acridine, phthalazine, anthracene and phenazine.

5.   A method as claimed in any preceding claim, in which the first resist layer is sensitive to ultraviolet radiation below 300 nanometer wavelength.

6.   A method as claimed in claim 5, in which the second resist layer is sensitive to ultraviolet radiation above 300 nanometer wavelength.

7.   A method as claimed in claim 5, in which the second resist layer is sensitive to actinic radiation.

8.   A method as claimed in claim 5, in which the second resist layer is sensitive to an electron beam.

9.    A method as claimed in any preceding claim, in which the first
      resist layer is sufficiently thick to planarize the surface
      topology of the substrate and the said second resist layer is
      relatively thin compared with the first resist layer.

10.   A method as claimed in any preceding claim, in which the
      ultraviolet radiation absorbing dopant material is introduced into
      the first and second resist layers by diffusion.

**FIG. 1**

**FIG. 2-A**

**FIG. 2B**

**FIG. 3A**

**FIG. 3B**